(19) Europäisches Patentamt / European Patent Office / Office européen des brevets

(11) **EP 3 640 630 B1**

(12) **EUROPEAN PATENT SPECIFICATION**

(45) Date of publication and mention
of the grant of the patent:
**11.03.2026  Bulletin 2026/11**

(21) Application number: **18201303.7**

(22) Date of filing: **18.10.2018**

(51) International Patent Classification (IPC):
*G01N 21/95* (2006.01)   *G01N 21/958* (2006.01)
*H01L 21/66* (2006.01)   *H01L 21/67* (2006.01)
*G06T 7/00* (2017.01)   *G01N 21/88* (2006.01)

(52) Cooperative Patent Classification (CPC):
**G01N 21/9505; G01N 21/958; G06T 7/001;**
**H10P 74/203;** G01N 2021/8832; G06T 2207/30148

(54) **EMBEDDED WAFER INSPECTION**

EINGEBETTETE WAFERINSPEKTION

INSPECTION DE PLAQUETTES INTÉGRÉES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**22.04.2020  Bulletin 2020/17**

(73) Proprietor: **Infineon Technologies AG**
**85579 Neubiberg (DE)**

(72) Inventors:
• **RINGSLEBEN, Frederic**
**04736 Waldheim (DE)**
• **SCHNEIDER, Germar**
**01109 Dresden (DE)**
• **MOTHES, Dirk**
**01109 Dresden (DE)**
• **FEHR, Matthias**
**01109 Dresden (DE)**

(74) Representative: **Maikowski & Ninnemann**
**Patentanwälte Partnerschaft mbB**
**Postfach 15 09 20**
**10671 Berlin (DE)**

(56) References cited:
**WO-A1-2011/121219**   **US-A1- 2010 165 095**
**US-A1- 2015 160 138**

**Description**

**TECHNICAL FIELD**

This specification refers to embodiments of a method of processing a wafer, wherein the method includes automatically analyzing the wafer. This specification further refers to embodiments of a system of processing a wafer, wherein the system includes an apparatus for automatically analyzing the wafer. This specification also refers to embodiments of an apparatus for automatically analyzing a wafer.

**BACKGROUND**

Many functions of modern devices in automotive, consumer and industrial applications, such as converting electrical energy and driving an electric motor or an electric machine, rely on power semiconductor devices. For example, power semiconductor devices, such as Insulated Gate Bipolar Transistors (IGBTs) and Metal Oxide Semiconductor Field Effect Transistors (MOSFETs) and diodes, have been used for various applications including, but not limited to switches in power supplies and power converters. Different kind of semiconductor technologies, such as CMOS (Complementary metal-oxide-semiconductor) technology, Bipolar technology, or a combination thereof, known as BiCMOS technology, may be applied for forming power semiconductor devices.

Power semiconductor devices are typically processed on/within a wafer. After having been processed, the wafer is typically diced into a plurality of separate power semiconductor dies. Damages of a power semiconductor die can lead to a functional deficiency of the power semiconductor die itself and, eventually, to a malfunction or a failure of the of the power semiconductor device (including one or more of such dies) or even of the application in which the respective power semiconductor device is used.

However, wafers not only serve as a basis for manufacturing power semiconductor dies, but for example also for manufacturing Integrated Circuits (ICs), microelectromechanical systems (MEMS), photoelectric components etc. Also in this context, the wafer should certainly be free of damages.

Also, further processing of damaged wafers may harm tools that are employed for the further processing.

Therefore, it may be desirable to reliably detect a damaged wafer and to control further processing accordingly.

US 2010/165095 A1 describes a defect inspection device for a silicon wafer, comprising: an infrared light illumination which illuminates the silicon wafer with a light power that has been adjusted in accordance with a specific resistance value of the silicon wafer; and an imaging unit constituted by a line sensor array that is sensitive to infrared light transmitted by the silicon wafer.

US 2015/160138 A1 describes an inspection apparatus for solar cells, including: a visible light source adapted to irradiate visible light; a CCD camera adapted to measure a reflection image based on the visible light reflected by an antireflective film of a solar cell; an infrared light source adapted to irradiate the solar cell with infrared light; and a CCD camera adapted to measure a transmission image based on the infrared light transmitting through the solar cell. In the inspection apparatus, as a result of comparing the reflection image and the transmission image with each other, of areas respectively appearing as bright spots in the reflection image, an area appearing as a dark spot in the transmission image is determined as an area including a particle, whereas of the areas respectively appearing as the bright spots in the reflection image, an area other than the area determined as the area including the particle is determined as an area including a pinhole.

WO 2011/121219 relates to a device for analyzing a transparent surface of a substrate, comprising a gauge disposed facing the surface of the substrate to be measured. The gauge is formed on a support of small and large extensions. A camera is provided so as to take at least one image of the gauge deformed by the measured substrate. A system for illuminating the gauge and means for processing the image and for numerical analysis are linked to the camera. The support is of oblong form, the gauge is monodirectional, consisting of a pattern which extends along the smallest extension of the support. The pattern is periodic transversely to the small extension, and the camera is linear.

**SUMMARY**

The subject-matter of the independent claims defines the invention. The dependent claims define features of preferred embodiments.

Aspects described herein relate to embedding a fully automatic wafer damage inspection, herein also referred to as wafer damage analysis, into the process chain of a wafer processing plant or a wafer production plant.

Embedding the wafer damage analysis within the process chain may for example occur by providing a separate analysis step somewhere between the first and the last processing step the wafer passes through.

Another variant is implementing the wafer damage analysis during one of the plurality of processing steps, e.g., simultaneously with at least one of a deposition processing step, a lithographic processing step, a wet processing step, an implantation processing step, an etch processing step, or simultaneously with any processing step related to deposition, removal, patterning, or modification of electrical properties of the wafer. For example, thereby, the throughput rate of the processing chain can be maintained; i.e., the wafer damage analysis may occur automatically without loss of time, e.g., in real-time with respect to the processing speed of the processing chain.

Regarding implementation of the automatic analysis, it is proposed to emit light with a reference light pattern that traverses the moving wafer. The light that has traversed the moving wafer, and, optionally, additional light that has been reflected by the wafer, is received and compared with a reference. An eventual difference can be indicative of a damage within the wafer.

According to the invention, a method of processing a wafer is defined in claim 1. The method includes automatically analyzing the wafer, wherein automatically analyzing the wafer comprises: effecting a relative movement between the wafer and a camera device; during the relative movement between the wafer and the camera device: subjecting the wafer to a light emitted by a light source, wherein the light source emits the light with a reference light pattern; and the emitted light penetrates the moving wafer; generating, by the camera device and based on the light that was emitted by the light source and penetrated the moving wafer, receipt image data indicative for a receipt light pattern; determining, by a processing unit, a difference between the reference light pattern and the receipt light pattern based on the receipt image data and reference image data; determining, by the processing unit and based on the difference, a quality parameter indicative for a material character of the wafer.

According to the invention, a system for processing a wafer is defined in claim 14. The system includes an apparatus for automatically analyzing the wafer, wherein the apparatus comprises: a camera device, a light source, a processing unit, and means for effecting a relative movement between the wafer and the camera device and so as to subject, during the relative movement between the wafer and the camera device, the wafer to a light emitted by the light source, wherein the light source emits the light with a reference light pattern, and wherein the emitted light penetrates the moving wafer; wherein: the camera device is configured to generate, based on the light that was emitted by the light source and penetrated the moving wafer, receipt image data indicative for a receipt light pattern; the processing unit is configured to determine a difference between the reference light pattern and the receipt light pattern based on the receipt image data and reference image data; the processing unit is configured to determine, based on the difference, a quality parameter indicative for a material character of the wafer.

According yet to the invention, an apparatus for automatically analyzing a wafer is defined in claim 13. The apparatus comprises: a camera device, a light source, a processing unit, and means for effecting a relative movement between the wafer and the camera device and so as to subject, during the relative movement between the wafer and the camera device, the wafer to a light emitted by the light source, wherein the light source emits the light with a reference light pattern, and wherein the emitted light penetrates the moving wafer; wherein: the camera device is configured to generate, based on the light that was emitted by the light source and penetrated the moving wafer, receipt image data indicative for a receipt light pattern; the processing unit is configured to determine a difference between the reference light pattern and the receipt light pattern based on the receipt image data and reference image data; and the processing unit is configured to determine, based on the difference, a quality parameter indicative for a material character of the wafer.

Within the scope of the present specification, the term "wafer" has the meaning the skilled person typically associates therewith.

For example, the wafer can be a product wafer, e.g., a wafer serving as a basis for manufacturing microelectronic components, such as power semiconductor dies, Integrated Circuits (ICs), micromechanical systems (MEMS), photoelectric components etc. Such wafer may also be referred to as "substrate". For example, the wafer is a semiconductor wafer (also referred to as semiconductor substrate).

In another example, the wafer is a carrier wafer. E.g., a carrier wafer may be used as an auxiliary wafer for processing thin semiconductor wafers. Also such type of wafer may also be referred to as "substrate". Carrier wafers are for example used to permit the safe handling of sensitive semiconductor wafers (e.g. those made of silicon and gallium arsenide). For example, the carrier wafer can be a glass wafer, a plastic wafer, or a semiconductor wafer.

In yet another example, the wafer is or forms a part of a wafer stack of two or more wafers that are, e.g., bonded to each other, e.g., for forming three-dimensional integrated circuits thereon (e.g. applying a technology referred to as TSV (through silicon via)). For example, the wafer can be a glass on silicon wafer, or a silicon on glass wafer. Also such wafer type may be referred to as substrate or, respectively, substrate stack.

Generally, the herein described embodiments are suited for analyzing arbitrary wafer types. It is pointed out the above mentioned wafer types may also be referred to as substrates. The material of the wafer being processed/analyzed (e.g., the substrate being processed/analyzed) may be a semiconductor material (e.g., Si, GaN, SiC, to name a few), a glass, or a plastic material.

As used herein, the term "processing the wafer" may refer to processing steps concerning the production of the wafer itself, or to processing steps regarding subsequent further processing of the wafer in terms of, e.g., forming microelectronic components thereon, such as power semiconductor dies, Integrated Circuits (ICs), micromechanical systems (MEMS), photoelectric components, etc..

Those skilled in the art will recognize additional features and advantages upon reading the following detailed description, and upon viewing the accompanying drawings.

## BRIEF DESCRIPTION OF THE DRAWINGS

The parts in the figures are not necessarily to scale, instead emphasis being placed upon illustrating principles of the invention. Moreover, in the figures, like reference numerals may designate corresponding parts. In the drawings:

Fig. 1      schematically and exemplarily illustrates a section of a vertical cross-section of a wafer;
Fig. 2      schematically and exemplarily illustrates a method of analyzing a wafer;
Fig. 3      schematically and exemplarily illustrates another method of analyzing a wafer;
Fig. 4      schematically and exemplarily illustrates a horizontal projection of a wafer having a plurality of components implemented thereon, in accordance with one or more embodiments;
Fig. 5      schematically and exemplarily illustrates a method of processing a wafer, the method including automatically analyzing the wafer, in accordance with one or more embodiments;
Fig. 6      schematically and exemplarily illustrates two variants of a reference light pattern that may be employed for automatically analyzing a wafer, in accordance with one or more embodiments;
Fig. 7      schematically and exemplarily illustrates a section of a system for processing a wafer, the system including an apparatus for automatically analyzing the wafer, in accordance with one or more embodiments;
Fig. 8      schematically and exemplarily illustrates a section of a system for processing a wafer, the system including an apparatus for automatically analyzing the wafer, in accordance with one or more embodiments;
Fig. 9      schematically and exemplarily illustrates a section of a system for processing a wafer, the system including an apparatus for automatically analyzing the wafer, in accordance with one or more embodiments; and
Fig. 10     schematically and exemplarily illustrates a flow diagram of a method of processing a wafer, the method including automatically analyzing the wafer, in accordance with one or more embodiments.

## DETAILED DESCRIPTION

In the following detailed description, reference is made to the accompanying drawings which form a part hereof and in which are shown by way of illustration specific embodiments in which the invention may be practiced.

In this regard, directional terminology, such as "top", "bottom", "below", "front", "behind", "back", "leading", "trailing", "above" etc., may be used with reference to the orientation of the figures being described. Because parts of embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

Reference will now be made in detail to various embodiments, one or more examples of which are illustrated in the figures. Each example is provided by way of explanation, and is not meant as a limitation of the invention. For example, features illustrated or described as part of one embodiment can be used on or in conjunction with other embodiments to yield yet a further embodiment. It is intended that the present invention includes such modifications and variations. The examples are described using specific language which should not be construed as limiting the scope of the appended claims. The drawings are not scaled and are for illustrative purposes only. For clarity, the same elements or manufacturing steps have been designated by the same references in the different drawings if not stated otherwise.

The term "horizontal" as used in this specification intends to describe an orientation substantially parallel to a horizontal surface. This can be for instance the surface of a wafer. For example, both the first lateral direction X and the second lateral direction Y mentioned below can be horizontal directions, wherein the first lateral direction X and the second lateral direction Y may be perpendicular to each other.

The term "vertical" as used in this specification intends to describe an orientation which is substantially arranged perpendicular to the horizontal surface, i.e., parallel to the normal direction of the surface of the substrate/wafer. For example, the extension direction Z mentioned below may be an extension direction that is perpendicular to both the first lateral direction X and the second lateral direction Y. The extension direction Z is also referred to as "vertical direction Z" herein.

Some exemplary embodiments described in this specification are related to, without being limited thereto, power semiconductor devices, e.g., power semiconductor devices that may be used within a power converter or a power supply. Thus, in an embodiment, such devices can be configured to carry a load current that is to be fed to a load and/or, respectively, that is provided by a power source. For example, the power semiconductor devices may comprise one or more active power semiconductor dies each having one or more active power semiconductor cells, such as a monolithically integrated diode cell, e.g., monolithically integrated cell of two anti-serially connected diodes, a monolithically integrated transistor cell, e.g., a monolithically integrated IGBT cell, a monolithically integrated MOSFET cell and/or derivatives thereof. Such diode/transistor cells may be integrated in an active region (cell field) of a power semiconductor die, which may then be integrated in a power semiconductor device.

The term "power semiconductor die" as used in this specification intends to describe a single power semiconductor chip with high voltage blocking and/or high current-carrying capabilities. In other words, such power semiconductor die is intended for high current, typically in the Ampere range, e.g., up to several ten or hundred Ampere, and/or high voltages, typically above 15 V, more typically 100 V and above, e.g., up to at least 400 V or even more, e.g., up to at least 3 kV.

A plurality of power semiconductor dies may be processed simultaneously on a wafer. After the plurality of power semiconductor dies have been processed on the wafer, the wafer may be subjected to a dicing step, during which the wafer is diced into the plurality of separate power semiconductor dies. A singular one of these dies or a plurality of these dies may then be integrated within a package, e.g., so as to form the power semiconductor device.

However, as also mentioned introductorily, wafers not only serve as a basis for manufacturing power semiconductor dies, but also for manufacturing other microelectronic components, such as Integrated Circuits (ICs), micromechanical systems (MEMS), photoelectric components etc.

It is usually desirable to guarantee correct functionality of the microelectronic components that are shipped out to the customer. To this end, checks/analyses/inspections may be carried out before, during and/or after the processing so as to ensure that functionally working and non-damaged components are shipped out.

The present specification is generally directed to manufacturing or processing a wafer of an arbitrary type, wherein manufacturing or processing the wafer includes an embedded analysis of the wafer. The wafer manufactured may for example be further processed by forming microelectronic components, such as power semiconductor dies, ICs, MEMS, photovoltaic devices and the like thereon. As mentioned introductorily, the wafer can be of any type, e.g., a glass wafer, a semiconductor wafer, a plastic wafer and so on. The wafer may even be based on several substrates, such as silicon-on-glass arrangements and so on.

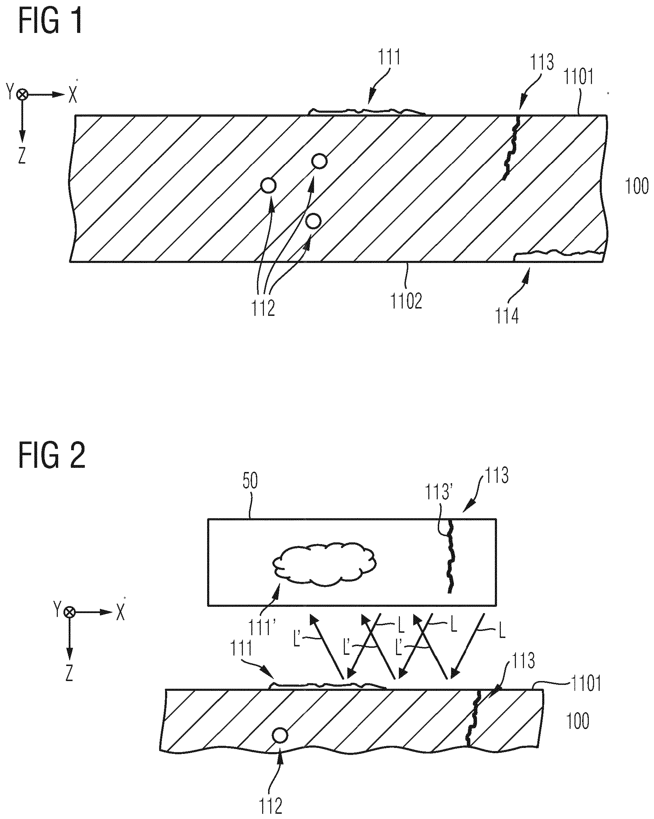

Regarding possible damages of the wafer, it is referred to Fig. 1, which schematically and exemplarily illustrates a section of a vertical cross-section of the wafer 100.

For example, a first type of a damage of the wafer 100 can be a contamination 111 on a front surface 1101 and/or on a back surface 1102 of the wafer 100. Such contamination can also be within the wafer 100.

Another type of damage that may additionally or alternatively occur is an inclusion 112 within the wafer 100.

Another type of damage that may additionally or alternatively occur is a crack 113 extending (e.g., from one of the front surface 1101 and the back surface 1102) into the wafer 100.

Yet another type of damage that may additionally or alternatively occur is an eruption or groove 114 of the wafer 100.

The aforementioned exemplary types of damages of the wafer 100 may lead to performance degradation or even malfunction of the components to be formed on/within the wafer 100.

Moreover, the damages may lead to performance degradation or even malfunction of a processing tool of the production plant currently processing the wafer. Hence, if a wafer having a damage is not detected (and, e.g., not accordingly sorted out) further processing of the damaged wafer may cause significant reduction of the throughput rate of the production plant.

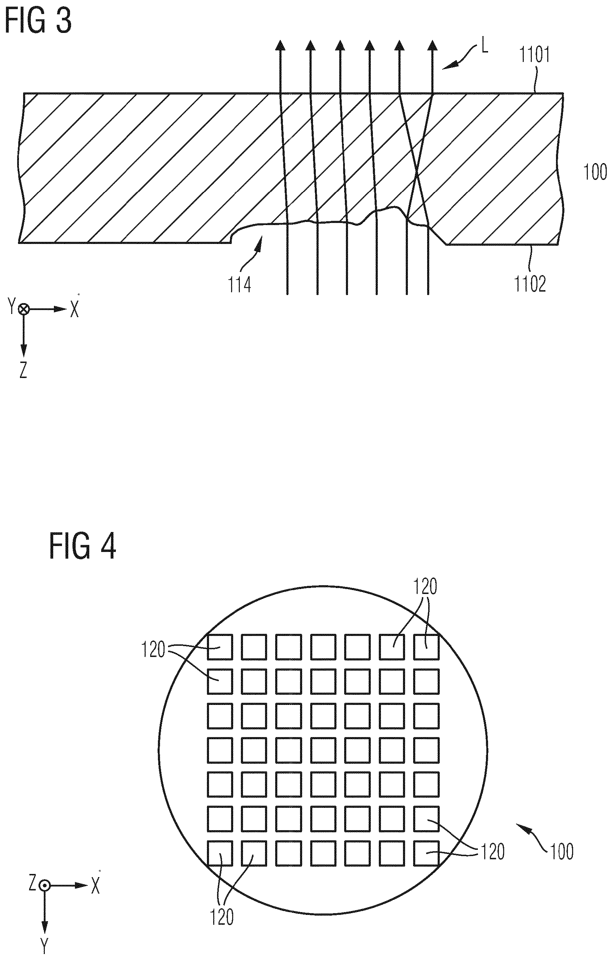

For example, referring to Fig. 4, which schematically and exemplarily illustrates a horizontal projection of the wafer 100, a plurality of microelectronic components 120, such as power semiconductor dies or other components (ICs, MEMs, ...) may be formed on/within the wafer 100, namely by applying typical device fabrication processing steps. Such processing steps can be related to deposition, removal, patterning, or modification of electrical properties of the wafer 100.

According to the aforesaid, the processing steps may not yield the desired effects if the wafer 100 exhibits damages, e.g., those as exemplarily described with respect to Fig. 1. Or, applying the processing steps may cause wafer damages, e.g., those as exemplarily described with respect to Fig. 1.

Hence, it is desirable to determine presence or non-presence of such damages 111, 112, 113 and 114 and to control further processing or, respectively, at least further handling of the wafer 100 based on the determination.

For example, with reference to Fig. 2, to make this determination, it is possible to direct light L in a tilted (with respect to the vertical direction Z) manner onto the surface 1101 of the wafer 100 and to analyze, by means of a camera, the image 50 that was obtained based on the reflected light L'. E.g., by applying image processing algorithms, the presence of the contamination 111 may be determined based on detecting a corresponding image portion 111' in the image 50, and presence of the crack 113 may be determined by detecting a corresponding image portion 113' in the image 50.

Another option, as schematically and exemplarily illustrated in Fig. 3, is to direct the light L through the wafer 100, i.e., such that it penetrates the back surface 1102 and the front surface 1101 and to analyze this light. E.g., thereby, presence of the eruption/groove 114 may be determined.

Aspects described herein relate to improving the determination of the presence of one or more wafer damages (such as the damages 111, 112, 113, 114 as exemplarily described above) with regards to efficiency and reliability. Herein, the efficiency of the damage analysis refers not necessarily exclusively to the total time needed for determining presence of the damage, but rather refers to the total time that is needed for processing the wafer, e.g., the throughput rate of the system currently processing the wafers. That is, the efficiency improvement is for example directed to the total time consumed by the processing chain of the process steps applied to the wafer 100, wherein the damage analysis is embedded in said processing chain. For example, the embedded damage analysis not only allows efficient detection of a damaged wafer, but also the prevention of further processing of a damaged wafer (that, e.g., could damage a processing tool employed during the wafer processing).

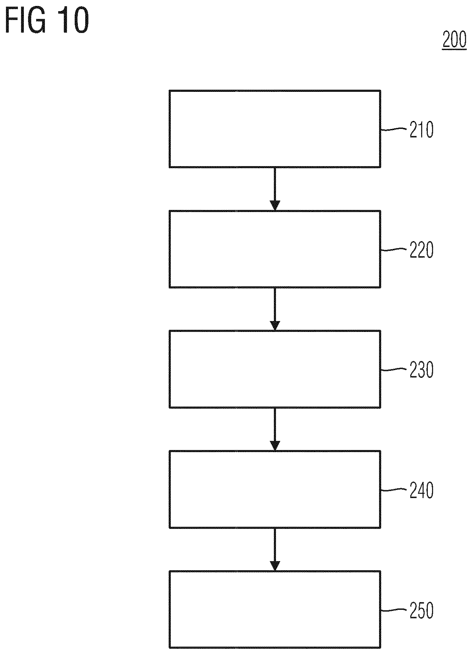

Fig. 10 schematically and exemplarily illustrates a flow diagram of a method 200 of processing a wafer 100 (cf. Fig. 4), the method 200 including automatically the wafer 100, in accordance with one or more embodiments.

As indicated above, the term "processing the wafer 100" may refer to processing steps concerning the production of the wafer itself, or to processing steps regarding subsequent further processing of the wafer in terms of, e.g., forming microelectronic components, such as power semiconductor dies, Integrated Circuits (ICs), micromechanical systems (MEMS), photoelectric components thereon. E.g., "processing the wafer 100" can designate a processing method applied for forming the plurality of microelectronic components 120 on/within the wafer 100, e.g., as shown in Fig. 4. Such processing steps can be related to deposition, removal, patterning, or modification of electrical properties of the wafer 100. Hence, as used herein "processing the wafer 100" may designate one, more or all processing steps of a processing chain that is executed for completely forming the microelectronic components (e.g., the power semiconductor dies, ICs, MEMS, photovoltaic devices etc.) 120 on/within the wafer 100.

In other embodiments, "processing the wafer 100" can designate a processing method directed only to manufacturing the wafer 100 itself, independently from the later use of the wafer 100. E.g., "processing the wafer" may refer to a method of producing a carrier wafer or a product wafer or a wafer stack.

As explained above, the wafer 100 can for example be one of a semiconductor wafer, or a glass wafer or a plastic wafer. The wafer 100 can have a diameter e.g. of "6 inch", "8 inch", "12 inch" or "16 inch", to give a few examples.

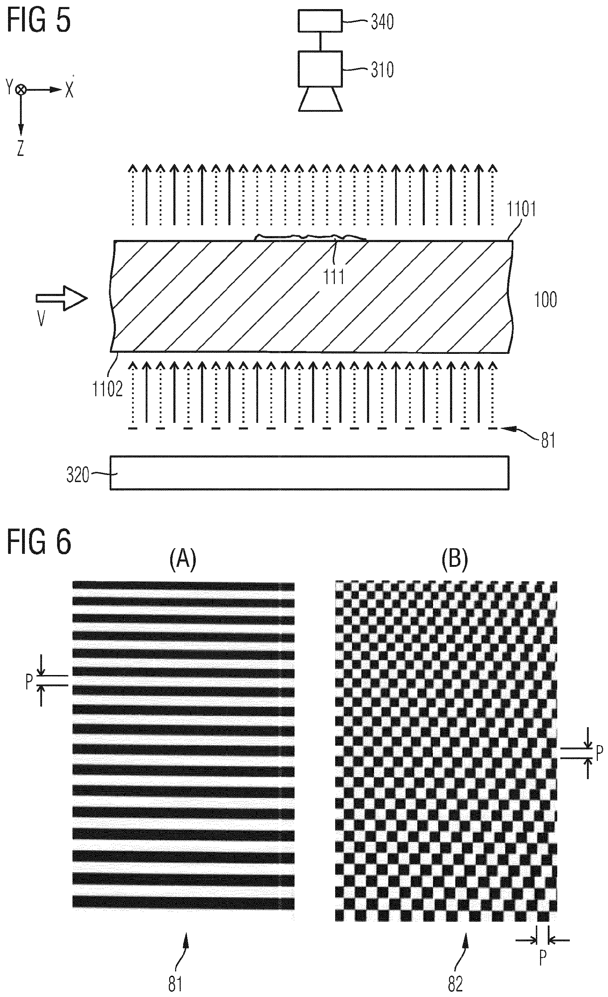

Automatically analyzing the wafer 100 comprises several steps, which will now be described with additional reference to Figs. 5, 6 and 7.

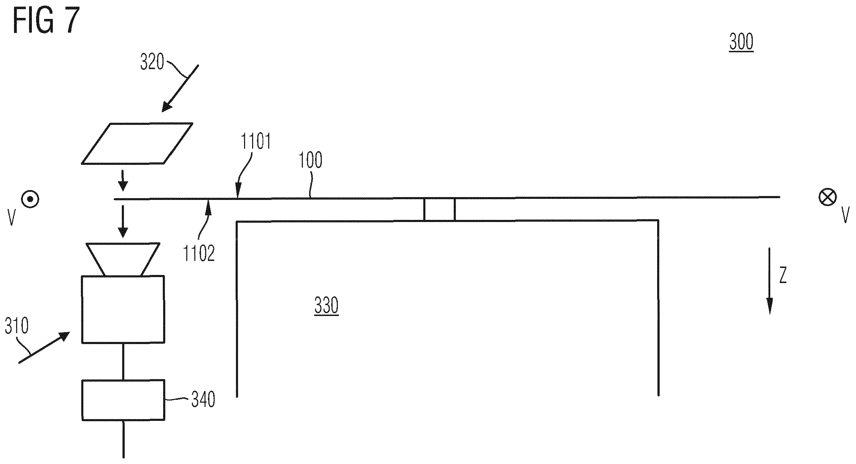

For example, step 210 includes effecting 210 a relative movement between the wafer 100 and a camera device 310. Such relative movement may be effected by moving only the wafer 100 and maintaining the camera device 310 stationary. For example, the relative movement between the wafer 100 and the camera device 310 is effected by a wafer aligner device 330 (cf. Fig. 7) used for the purpose of processing the wafer 100.

The relative movement may be a linear movement of the wafer 100 or a rotational movement of the wafer 100. For example, a velocity of the wafer movement may be within the range of 0,001 m/s to 100 m/s (in case of a linear movement), or within the range of 0,01 rpm to 1000 rpm (in case of a rotational movement).

The camera device 310 may be digital camera device, e.g., a commercially available off-the-shelve camera device. The camera device 310 may operate by repeatedly capturing images of the moving wafer 100, e.g., at a sampling rate of 1 - 1000 images per second, and at an image capture time t within the range of 0,001 ms to 100 ms for each image, and outputting corresponding receipt image data. Recording the images may require the image capture time t for each image. At least one of the sampling rate and the image capture time t may be adjustable.

The camera device 310 may be positioned at a distance to the wafer 100 so as to be capable of obtaining image data in sufficient quality, e.g., a distance within 0,01 cm to 5 cm, or within 0,1 cm to 100 cm. A distance that may be appropriate for some embodiments amounts to about 3 cm.

Step 220, which may be carried out simultaneously with step 210 (i.e., during relative movement between the wafer 100 and the camera device 310), includes subjecting the wafer 100 to a light emitted by a light source 320, in accordance with an embodiment.

For example, the light source 320 emits the light with a reference light pattern. Two exemplary light patterns A, B are illustrated in Fig. 6. Hence, the reference light pattern can be for example one of a stripe pattern 81 and a checkerboard pattern 82. For example, a maximum pitch P of the reference light pattern 81; 82 is adapted to the image capture time t of the camera device 310. E.g., a smaller pitch P may require a shorter image capture time t.

For emitting light with the reference light pattern, in one embodiment, the light source 320 produces homogenous light that passes through a mask (not illustrated) before reaching the wafer 100, wherein the mask effects the reference light pattern. In another embodiment, the light source 320 may comprise a controllable light panel, such as a controllable LED panel, and the light source 320 may be configured to output the light with the reference light pattern based on correspondingly controlling the light panel.

For example, the light source 320 emits light within the visual spectrum or within the infrared spectrum. For special purposes, even light sources with higher frequencies can be used e.g. UV light sources.

Still referring to step 220, and as more clearly illustrated in Fig. 5, the light emitted by the light source 320 penetrates the moving wafer 100. For example, the light emitted by the light source 320 may enter the wafer 100 at the wafer back surface 1102 and leave the wafer 100 at the wafer front surface 1101, or vice versa. For example, the wafer surfaces 1101 and 1102 may be orientated substantially perpendicular to the light emission direction (as indicated by the

EP 3 640 630 B1

vertical arrows in Fig. 5).

In an embodiment, there may be provided a non-illustrated additional light source that directs additional light onto the wafer front surface 1101 such that the additional light is reflected by the wafer front surface 1101 and thereafter captured by the camera device 310.

In accordance with an embodiment, the wafer movement v may occur in a direction substantially perpendicular to the light emission direction of the light emitted by the light source 320 (as indicated by the vertical arrows in Fig. 5).

For example, with respect to the light emission direction (as indicated by the vertical arrows in Fig. 5), the wafer 100 is moved between the camera device 310 and the light source 320. Both the camera device 310 and the light source 320 may be installed stationary, e.g., in a manner that the light source 320 emits the light towards the camera device 310, wherein the emitted light passes though the moving wafer 100 before reaching the camera device 310.

Hence, in an embodiment, the camera device 310 uses transmitted light (instead or in addition to light reflected by the wafer 100 (as in Fig. 2)) for generating the image data.

In Fig. 5, emission of the light with the reference light pattern is indicated by means of the bold and dotted arrows. Hence, between the moving wafer 100 and the light source 320, the emitted light may exhibit the reference light pattern, such as the stripe pattern 81, as schematically and exemplarily illustrated in Fig. 6, e.g., a patterned change between minimum (dotted arrows) and maximum light emission (solid arrow). Such light then traverses the moving wafer 100. If the wafer 100 does not exhibit any damage, the reference light pattern is not disturbed, as schematically and exemplarily illustrated in the left and right portions of Fig. 5. However, regarding for example the central portion of the wafer 100 where the wafer 100 exhibits the contamination 111, the reference light pattern is disturbed, yielding reception of a receipt light pattern at the camera device 310 different from the reference light pattern.

Further, in an embodiment, the image capture time t of the camera device 310, a maximum length $l$ of a wafer section captured by the camera device 310, and the velocity $v$ of the relative movement are set to each other so as to fulfill the condition

$$t = l/v \qquad\qquad (1)$$

The maximum length $l$ of the wafer section captured by the camera device 310 may for example be adjusted according to the current camera device control (e.g., its optical focus/range) and/or the distance between the camera device 310 and the wafer 100.

The image capture time t of the camera device 310 can be predetermined or adjustable, depending of the type of the camera device 310.

The velocity v can for example be controlled by correspondingly setting the means effecting the velocity. Such means may for example include the aligner device 330 as schematically shown in Fig. 7, where the movement is a rotational movement indicated by the arrow head and the arrow foot.

By setting the parameters $t$, $l$ and $v$ so as to fulfill, at least substantially, condition (1), it is for example possible to ensure that the section of the wafer 100 having length $l$ and currently being recorded by the camera device 310 is sufficiently illuminated (in terms of total illumination time) by the light source 320. Further, it can be ensured that only one image is recorded for wafer section of length $l$. The next image is recorded for the subsequent wafer section of length $l$, wherein it can be ensured that there is neither an overlap between adjacent wafer sections nor a gap, in accordance with an embodiment.

Step 230 includes generating, by the camera device 310 and based on the light that was emitted by the light source 320 and penetrated the moving wafer 100, receipt image data indicative for the receipt light pattern.

For example, step 230 may include continuously recording images, at the image sampling rate and with the image capture time t for each image, of the illuminated moving wafer 100 and providing the corresponding receipt image data.

A processing unit 340 can be connected to the camera unit 310 and configured to receive the receipt image data from the camera unit 310. Of course, the processing unit 340 and the camera unit 310 may be integral parts of a camera apparatus.

In step 240, a difference between the reference light pattern and the receipt light pattern is determined, based on the receipt image data and reference image data.

For example, this difference is determined for each recorded image.

Before the difference is determined, the receipt image data may be subjected to a noise cancellation algorithm. Further, before the difference is determined, the receipt image data may be subjected to an edge cancellation algorithm for filtering out deviations caused by an edge of the wafer. The difference which is thereafter (after applying the noise and edge cancellation algorithms) determined may then be indicative for eventual wafer damages.

The noise cancellation algorithm can for example be based on a Gaussian filter or on a non-linear filter, such as a median filter.

Applying the edge cancellation algorithm may be appropriate if the recorded wafer section includes an image of an edge of the wafer 100. The edge of the wafer 100, i.e., the substantially vertically extending termination between the two wafer surfaces 1101 and 1102, may break the light irregularly and could thereby falsely indicate a wafer damage. For example, the edge cancellation algorithm is based on thresholding, which is a known image processing technique regarding segmentation.

The reference image data can be indicative of the reference light pattern. In an embodiment, the reference image data can be produced based on averaged receipt image data obtained during previous measurements. For example, within the scope of these measurements, a damage-free wafer is used as a reference.

Determining the difference between the reference light pattern and the receipt light pattern based on the receipt image data and reference image data may for example include, e.g., after pre-processing the receipt image data by subjecting the receipt image data to the noise and/or edge cancellation algorithm, forming a difference between the reference image data and the (pre-processed) receipt image data and, e.g., by applying one or more standard algorithms, like segmentation algorithms, e.g., a watershed image processing algorithm, a livewire image processing algorithm, or a region growing image processing algorithm.

Automatically analyzing the wafer 100 within the scope of processing the wafer 100 includes determining, in step 250, by the processing unit 340 and based on the difference between the reference light pattern and the receipt light pattern, a quality parameter that is indicative for a material character of the wafer 100.

In a simple form, the quality parameter can be a binary parameter, a first value of which indicating presence of a wafer damage, a second value of which indicating absence of a wafer damage.

In other embodiments, the quality parameter may be more distinguished. However, the determining step 250 is primarily carried out so as to determine whether the wafer 100 is free of damages, i.e., fulfills a quality criterion and may hence be further processed, or whether the wafer 100 has a damage that disqualifies wafer 100 from being eventually shipped out to the customer.

Nevertheless, further embodiments in this regard are conceivable. For example, the determining step 240 and the determining step 250 may be carried out so as to classify the type of damage and/or so as to localize the damage. A corresponding quality parameter would then be output by the processing unit 340, indicating type and/or position of the damage. For example, in order to classify the type of damage and/or in order to localize the damage, it may be appropriate to change the reference light pattern periodically during the image capturing.

In an embodiment, determining, in step 250, the quality parameter indicative for the material character of the wafer 100, may include carrying out at least one of an edge oriented segmentation algorithm or region orientated segmentation algorithm for gathering pixels of the receipt image data to components and/or a classification algorithm. Basically, for determining the quality parameter, standard image processing algorithms may be employed.

In accordance with an embodiment, the method 200 of processing the wafer 100 not only includes automatically analyzing the wafer 100, e.g., in a manner as exemplarily described above, but also controlling the processing of the wafer 100 based on the quality parameter. For example, if the quality parameter indicates that the wafer 100 is damaged, the process may be organized such that the damaged wafer is sorted out and not further processed.

As has already been introductorily described, automatically analyzing the wafer 100 may occur during processing of the wafer 100. For example, automatically analyzing the wafer 100 occurs during a deposition processing step, a removal processing step, a patterning processing step, or during a processing step related to the modification of electrical properties of the wafer 100.

In another embodiment, automatically analyzing the wafer 100 may occur between two processing steps, i.e., as a separate immediate processing step after the first processing step has been finished and before a subsequent processing step is started.

Presented herein is also a system for processing a wafer. Exemplary embodiments are schematically illustrated in Figs. 7, 8 and 9.

The system 300 may be configured to carry out the process, entirely or at least partially, used for forming the microelectronic components 120 on/within the wafer 100. Hence, the system 300 may comprise the non-illustrated means for carrying out the deposition processing step(s), the removal processing step(s), the patterning processing step(s), and/or the processing step(s) related to the modification of electrical properties of the wafer 100. In other embodiments, the system 300 is a system for wafer manufacturing, only, independent of the later use of the wafer, e.g., as a carrier wafer, a product wafer, a wafer stack, e.g., independent of what type of components (ICs, power semiconductor dies, MEMS, photovoltaic, etc.) are later implemented on/within the wafer 100.

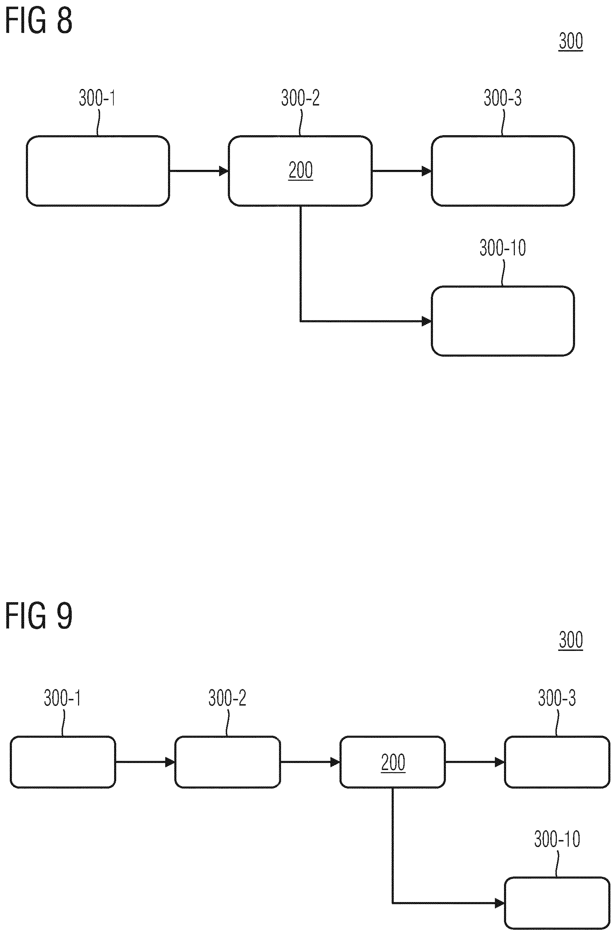

For example, referring to Figs. 8 and 9, processing steps 300-1, 300-2, 300-3 are illustrated, each of which is carried out by the system 300. Each of the processing steps 300-1, 300-2 and 300-3 can implement one of a deposition processing step, a removal processing step, a patterning processing step, and/or a processing step(s) related to the modification of electrical properties of the wafer 100.

Subsequent steps, such as testing, preparation, packaging and the like may be carried out by one or more other systems receiving the wafer 100 processed by the system 300.

The system 300 includes an apparatus for automatically analyzing the wafer 100, wherein the apparatus comprises: a camera device, a light source, a processing unit, and means for effecting a relative movement between the wafer and the camera device and so as to subject, during the relative movement between the wafer and the camera device, the wafer to a light emitted by the light source, wherein the light source emits the light with a reference light pattern, and wherein the emitted light penetrates the moving wafer. The camera device is configured to generate, based on the light that was emitted by the light source and penetrated the moving wafer, receipt image data indicative for a receipt light pattern. The processing unit is configured to determine a difference between the reference light pattern and the receipt light pattern based on the receipt image data and reference image data. The processing unit is configured to determine, based on the difference, a quality parameter indicative for a material character of the wafer.

It is emphasized that, herein, the above described apparatus is not only presented as part of the system 300, but also as an apparatus separate and independent of the system 300.

Regarding exemplary embodiments of the system 300 and its apparatus for automatically analyzing the wafer 100, it is fully referred to above described embodiments of the method 200 and the components that may be employed for carrying out the method 200. Hence, exemplary embodiments of the system 300 and its apparatus correspond to the exemplary embodiments of the method 200.

For example, the system 300 is configured to carry out one or more of the above described embodiments of the method 200.

Now referring to Figs. 8 and 9, two variants of including the apparatus within the system 300 shall be explained.

According to the embodiment illustrated in Fig. 8, the apparatus is included in the system 300 such that both the processing step 300-2 applied to the wafer 100 and automatically analyzing the wafer 100, e.g., in accordance with method 200, may occur simultaneously. Hence, performing the automatic analysis of the wafer 100 does not increase the total processing time needed for processing the wafer 100 by the system 300. For example, if the obtained quality parameter indicates that the wafer 100 is not damaged, the wafer 100 may be subjected to the subsequent processing step 300-3. If the obtained quality parameter indicates that the wafer 100 is damaged, the wafer 100 may be sorted out and, for example, be subjected to a separate processing step 300-10, where, for example, further measurements and/or inspections may be made.

According to the embodiment illustrated in Fig. 9, the apparatus is included in the system 300 such that automatically analyzing the wafer 100, e.g., in accordance with method 200, occurs within a separate processing step, e.g., after processing step 300-2 is completed and before the wafer 100 is subjected to processing steps 300-3 starts. Again, if for example the obtained quality parameter indicates that the wafer 100 is not damaged, the wafer 100 may be subjected to the subsequent processing step 300-3. If the obtained quality parameter indicates that the wafer 100 is damaged, the wafer 100 may be sorted out and, for example, be subjected to the separate processing step 300-10, where, for example, further measurements and/or inspections may be made.

Irrespective of whether the automatic analysis of the wafer 100 is carried out during a processing step or in between two processing steps, manual inspection of the wafer 100 can be avoided, in accordance with an embodiment. Hence, the degree of automatization of the system 300 can be increased. Taking into account that further processing of a damaged wafer may even harm the system 300, the above described embodiments may even render the operation of the wafer processing system 300 more reliable and more efficient.

Further, integration of the apparatus within an existing processing chain of a wafer production/processing plant can be possible without changing the process flow of the processing chain. Also, multiple integration of wafer damage analysis apparatuses is possible; e.g., the wafer damage analysis may occur serval times at different processing steps of the process chain.

In the above, embodiments pertaining to wafers, e.g., suited for forming power semiconductor devices, and corresponding processing methods were explained. For example, these wafers are semiconductor substrates, i.e., the wafer 100 can be based on silicon (Si). Accordingly, a monocrystalline semiconductor region or layer can be a monocrystalline Si-region or Si-layer. In other embodiments, polycrystalline or amorphous silicon may be employed.

It should, however, be understood that the wafer 100 can be made of any semiconductor material. Examples of such materials include, without being limited thereto, elementary semiconductor materials such as silicon (Si) or germanium (Ge), group IV compound semiconductor materials such as silicon carbide (SiC) or silicon germanium (SiGe), binary, ternary or quaternary III-V semiconductor materials such as gallium nitride (GaN), gallium arsenide (GaAs), gallium phosphide (GaP), indium phosphide (InP), indium gallium phosphide (InGaPa), aluminum gallium nitride (AlGaN), aluminum indium nitride (AlInN), indium gallium nitride (InGaN), aluminum gallium indium nitride (AlGaInN) or indium gallium arsenide phosphide (InGaAsP), and binary or ternary II-VI semiconductor materials such as cadmium telluride (CdTe) and mercury cadmium telluride (HgCdTe) to name few. The aforementioned semiconductor materials are also referred to as "homojunction semiconductor materials". When combining two different semiconductor materials a heterojunction semiconductor material is formed. Examples of heterojunction semiconductor materials include, without being limited thereto, aluminum gallium nitride (AlGaN)-aluminum gallium indium nitride (AlGaInN), indium gallium nitride (InGaN)-aluminum gallium indium nitride (AlGaInN), indium gallium nitride (InGaN)-gallium nitride (GaN), aluminum gallium nitride (AlGaN)-gallium nitride (GaN), indium gallium nitride (InGaN)-aluminum gallium nitride (AlGaN), silicon-silicon carbide (SixC1-x) and silicon-SiGe heterojunction semiconductor materials. For power semiconductor switch applications currently mainly Si, SiC, GaAs and GaN materials are used.

Spatially relative terms such as "under", "below", "lower", "over", "upper" and the like, are used for ease of description to explain the positioning of one element relative to a second element. These terms are intended to encompass different orientations of the respective device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising", "exhibiting" and the like are open ended terms that indicate the presence of stated elements or features, but do not preclude additional elements or features.

With the above range of variations and applications in mind, it should be understood that the present invention is not limited by the foregoing description, nor is it limited by the accompanying drawings. Instead, the present invention is limited only by the following claims.

## Claims

1. A method (200) of processing a wafer (100), the method (200) including automatically analyzing the wafer, wherein automatically analyzing the wafer (100) comprises:

   - effecting (210) a relative movement between the wafer (100) and a camera device (310), wherein the relative movement is a rotational movement;
   - during the relative movement between the wafer (100) and the camera device (310): subjecting (220) the wafer (100) to a light emitted by a light source (320), wherein

     - the light source (320) emits the light with a reference light pattern; and
     - the emitted light penetrates the moving wafer (100);

   - generating (230), by the camera device (310) and based on the light that was emitted by the light source (320) and penetrated the moving wafer (100), receipt image data indicative for a receipt light pattern, wherein a maximum pitch (P) of the reference light pattern is adapted to an image capture time of the camera device (310);
   - determining (240), by a processing unit (340), a difference between the reference light pattern and the receipt light pattern based on the receipt image data and reference image data;
   - determining (250), by the processing unit (340) and based on the difference, a quality parameter indicative for a material character of the wafer (100).

2. The method (200) of claim 1, further comprising controlling further processing of the wafer (100) based on the quality parameter.

3. The method (200) of claim 1 or 2, wherein automatically analyzing the wafer (100) occurs during processing of the wafer (100).

4. The method (200) of one of the preceding claims, wherein the quality parameter indicates presence or non-presence of at least one of the following:

   - a contamination (111) on a surface (1101, 1102) of the wafer (100) or within the wafer (100);
   - an inclusion (112) within the wafer (100);
   - a crack (113) extending into the wafer (100);
   - an eruption or groove (114) of the wafer (100).

5. The method (200) of one of the preceding claims, wherein the reference light pattern is one of a stripe pattern (81) and a checkerboard pattern (82).

6. The method (200) of one of the preceding claims, wherein the emitted light is within the visual spectrum or within the infrared spectrum or within the ultraviolet, UV, spectrum.

7. The method (200) of one of the preceding claims, wherein the wafer (100) is one of the following: a semiconductor wafer, a glass wafer, a plastic wafer, or a wafer of a wafer stack.

8. The method (200) of one of the preceding claims, wherein an image capture time t of the camera device (310), a maximum length *l* of a wafer section captured by the camera device (310), and a velocity *v* of the relative movement are set to each other so as to fulfill the condition $t = l/v$.

9. The method (200) of one of the preceding claims, wherein, before determining (240) the difference between the reference light pattern and the receipt light pattern based on the receipt image data and the reference image data, at least one of the following is carried out:

- subjecting the receipt image date to a noise cancellation algorithm; and
- producing the reference image data based on averaged receipt image data obtained during previous measurements.

10. The method (200) of one of the preceding claims, wherein determining (250) the quality parameter indicative for the material character of the wafer (100) includes carrying out at least one of:

- a segmentation algorithm; and
- a classification algorithm.

11. The method (200) of one of the preceding claims, wherein the relative movement between the wafer (100) and the camera device (310) is effected by a wafer aligner device (330).

12. The method (200) of one of the preceding claims, wherein the receipt image data is generated further based on light that was reflected by the wafer (100).

13. An apparatus for automatically analyzing a wafer (100), wherein the apparatus comprises

- a camera device (310), a light source (320), a processing unit (340), and means (330) for effecting a relative movement between the wafer (100) and the camera device (310) and so as to subject, during the relative movement between the wafer (100) and the camera device (310), the wafer (100) to a light emitted by the light source (320), wherein the light source (320) emits the light with a reference light pattern, and wherein the emitted light penetrates the moving wafer (100), and wherein the relative movement is a rotational movement;

wherein:

- the camera device (310) is configured to generate, based on the light that was emitted by the light source (320) and penetrated the moving wafer (100), receipt image data indicative for a receipt light pattern, wherein a maximum pitch (P) of the reference light pattern is adapted to an image capture time of the camera device (310);
- the processing unit (340) is configured to determine a difference between the reference light pattern and the receipt light pattern based on the receipt image data and reference image data;
- the processing unit (340) is configured to determine, based on the difference, a quality parameter indicative for a material character of the wafer (100).

14. A system (300) for processing a wafer (100), the system including an apparatus according to claim 13.

**Patentansprüche**

1. Verfahren (200) zur Verarbeitung eines Wafers (100), wobei das Verfahren (200) automatisches Analysieren des Wafers aufweist, wobei das automatische Analysieren des Wafers (100) Folgendes umfasst:

- Bewirken (210) einer relativen Bewegung zwischen dem Wafer (100) und einer Kameravorrichtung (310), wobei die relative Bewegung eine Drehbewegung ist;
- während der relativen Bewegung zwischen dem Wafer (100) und der Kameravorrichtung (310): Aussetzen (220) des Wafers (100) gegenüber Licht, das von einer Lichtquelle (320) emittiert wird, wobei
- die Lichtquelle (320) das Licht mit einem Referenzlichtmuster emittiert; und
- das emittierte Licht durch den sich bewegenden Wafer (100) durchdringt;
- Erzeugen (230) von Empfangsbilddaten, die ein Empfangslichtmuster angeben, durch die Kameravorrichtung (310) und basierend auf dem Licht, das von der Lichtquelle (320) emittiert wurde und durch den sich bewegenden Wafer (100) durchgedrungen ist, wobei ein maximaler Abstand (P) des Referenzlichtmusters an eine Bildaufnahmezeit der Kameravorrichtung (310) angepasst ist;
- Bestimmen (240) einer Differenz zwischen dem Referenzlichtmuster und dem Empfangslichtmuster durch eine Verarbeitungseinheit (340) basierend auf den Empfangsbilddaten und Referenzbilddaten;
- Bestimmen (250) eines Qualitätsparameters, der eine Materialeigenschaft des Wafers (100) angibt, durch die Verarbeitungseinheit (340) und basierend auf der Differenz.

2. Verfahren (200) nach Anspruch 1, ferner umfassend Steuern der Weiterverarbeitung des Wafers (100) basierend auf dem Qualitätsparameter.

3. Verfahren (200) nach Anspruch 1 oder 2, wobei das automatische Analysieren des Wafers (100) während der Verarbeitung des Wafers (100) stattfindet.

4. Verfahren (200) nach einem der vorhergehenden Ansprüche, wobei der Qualitätsparameter das Vorhandensein oder Nichtvorhandensein von mindestens einem von Folgenden angibt:

- einer Verunreinigung (111) auf einer Oberfläche (1101, 1102) des Wafers (100) oder innerhalb des Wafers (100);
- einem Einschluss (112) innerhalb des Wafers (100);
- einem Riss (113), der sich in den Wafer (100) erstreckt;
- einem Durchbruch oder einer Vertiefung (114) des Wafers (100).

5. Verfahren (200) nach einem der vorhergehenden Ansprüche, wobei das Referenzlichtmuster ein Streifenmuster (81) oder ein Schachbrettmuster (82) ist.

6. Verfahren (200) nach einem der vorhergehenden Ansprüche, wobei das emittierte Licht innerhalb des sichtbaren Spektrums oder innerhalb des Infrarotspektrums oder innerhalb des Ultraviolett-Spektrums, UV-Spektrums, liegt.

7. Verfahren (200) nach einem der vorhergehenden Ansprüche, wobei der Wafer (100) einer von folgenden ist: ein Halbleiterwafer, ein Glaswafer, ein Kunststoffwafer oder ein Wafer eines Waferstapels.

8. Verfahren (200) nach einem der vorhergehenden Ansprüche, wobei eine Bildaufnahmezeit t der Kameravorrichtung (310), eine maximale Länge l eines Waferabschnitts, der von der Kameravorrichtung (310) aufgenommen wird, und eine Geschwindigkeit v der relativen Bewegung so aufeinander eingestellt werden, dass die Bedingung t = l/v erfüllt wird.

9. Verfahren (200) nach einem der vorhergehenden Ansprüche, wobei vor dem Bestimmen (240) der Differenz zwischen dem Referenzlichtmuster und dem Empfangslichtmuster basierend auf den Empfangsbilddaten und den Referenzbilddaten mindestens eines von Folgendem ausgeführt wird:

- Unterziehen der Empfangsbilddaten einem Rauschunterdrückungsalgorithmus; und
- Erzeugen der Referenzbilddaten basierend auf gemittelten Empfangsbilddaten, die bei früheren Messungen erhalten wurden.

10. Verfahren (200) nach einem der vorhergehenden Ansprüche, wobei das Bestimmen (250) des Qualitätsparameters, der die Materialeigenschaft des Wafers (100) angibt, Ausführen mindestens eines von Folgenden aufweist:

- eines Segmentierungsalgorithmus; und
- eines Klassifizierungsalgorithmus.

11. Verfahren (200) nach einem der vorhergehenden Ansprüche, wobei die relative Bewegung zwischen dem Wafer (100) und der Kameravorrichtung (310) durch eine Waferjustiervorrichtung (330) bewirkt wird.

12. Verfahren (200) nach einem der vorhergehenden Ansprüche, wobei die Empfangsbilddaten ferner basierend auf Licht erzeugt werden, das von dem Wafer (100) reflektiert wurde.

13. Einrichtung zum automatischen Analysieren eines Wafers (100), wobei die Einrichtung Folgendes umfasst:

- eine Kameravorrichtung (310), eine Lichtquelle (320), eine Verarbeitungseinheit (340) und Mittel (330), um eine relative Bewegung zwischen dem Wafer (100) und der Kameravorrichtung (310) zu bewirken und den Wafer (100) während der relativen Bewegung zwischen dem Wafer (100) und der Kameravorrichtung (310) einem Licht auszusetzen, das von der Lichtquelle (320) emittiert wird, wobei die Lichtquelle (320) das Lichtmuster mit einem Referenzlichtmuster emittiert und wobei das emittierte Licht durch den sich bewegenden Wafer (100) durchdringt und wobei die relative Bewegung eine Drehbewegung ist;

wobei:

- die Kameravorrichtung (310) dazu ausgelegt ist, basierend auf dem Licht, das von der Lichtquelle (320) emittiert wurde und durch den sich bewegenden Wafer (100) durchgedrungen ist, Empfangsbilddaten zu erzeugen, die ein Empfangslichtmuster angeben, wobei ein maximaler Abstand (P) des Referenzlichtmusters an eine Bildaufnahmezeit der Kameravorrichtung (310) angepasst ist;
- die Verarbeitungseinheit (340) dazu ausgelegt ist, eine Differenz zwischen dem Referenzlichtmuster und dem Empfangslichtmuster basierend auf den Empfangsbilddaten und Referenzbilddaten zu bestimmen;
- die Verarbeitungseinheit (340) dazu ausgelegt ist, basierend auf der Differenz einen Qualitätsparameter zu bestimmen, der eine Materialeigenschaft des Wafers (100) angibt.

14. System (300) zum Verarbeiten eines Wafers (100), wobei das System eine Einrichtung nach Anspruch 13 aufweist.

## Revendications

1. Un procédé (200) de traitement d'une plaquette (100), le procédé (200) comprenant analyser automatiquement la plaquette, dans lequel analyser automatiquement la plaquette (100) comprend :

   - effectuer (210) un mouvement relatif entre la plaquette (100) et un dispositif (310) à caméra, dans lequel le mouvement relatif est un mouvement de rotation ;
   - pendant le mouvement relatif entre la plaquette (100) et le dispositif (310) à caméra : soumettre (220) la plaquette (100) à une lumière émise par une source (320) lumineuse, dans lequel

      - la source (320) lumineuse émet la lumière avec une configuration de lumière de référence ; et
      - la lumière émise pénètre dans la plaquette (100) en mouvement ;

   - créer (230), par le dispositif (310) à caméra et sur la base de la lumière qui était émise par la source (320) lumineuse et qui a pénétré dans la plaquette (100) en mouvement, une donnée d'image de réception indiquant une configuration de lumière de réception, dans lequel un pas (P) maximum de la configuration de lumière de référence est adapté à un temps de capture d'image du dispositif (310) à caméra ;
   - déterminer (240), par une unité (340) de traitement, une différence entre la configuration de lumière de référence la configuration de lumière de réception sur la base de la donnée d'image de réception et de la donnée d'image de référence ;
   - déterminer (250), par l'unité (340) de traitement et sur la base de la différence, un paramètre de qualité indiquant un caractère de matériau de la plaquette (100).

2. Le procédé (200) de la revendication 1, comprenant en outre commander un traitement ultérieur de la plaquette (100) sur la base du paramètre de qualité.

3. Le procédé (200) de la revendication 1 ou 2, dans lequel analyser automatiquement la plaquette (100) a lieu pendant le traitement de la plaquette (100).

4. Le procédé (200) de l'une des revendications précédentes, dans lequel le paramètre de qualité indique la présence ou la non présence d'au moins l'un de ce qui suit :

   - une pollution (111) à la surface (1101, 1102) de la plaquette (100) ou au sein de la plaquette (100) ;
   - une inclusion (112) au sein de la plaquette (100) ;
   - une fissure (113) s'étendant dans la plaquette (100) ;
   - une éruption ou une rainure (114) de la plaquette (100).

5. Le procédé (200) de l'une des revendications précédentes, dans lequel la configuration de lumière de référence est l'une d'une configuration (81) en bande ou d'une configuration (82) en damier.

6. Le procédé (200) de l'une des revendications précédentes, dans lequel la lumière émise est dans le spectre visuel ou dans le spectre infrarouge ou dans le spectre ultraviolet, UV.

7. Le procédé (200) de l'une des revendications précédentes, dans lequel la plaquette (100) est l'une des suivantes : une plaquette à semiconducteur, une plaquette de verre, une plaquette de matière plastique ou une plaquette d'un empilement de plaquettes.

8. Le procédé (200) de l'une des revendications précédentes, dans lequel un temps t de prise d'image du dispositif (310) à caméra, une longueur $l$ maximum d'une partie de la plaquette captée par le dispositif (310) à caméra et une vitesse v du mouvement relatif sont réglés les uns par rapport aux autres de manière à satisfaire la condition $t=l/v$.

9. Le procédé (200) de l'une des revendications précédentes, dans lequel, avant de déterminer (240) la différence entre la configuration de lumière de référence et la configuration de lumière de réception sur la base de l'image de réception et de la donnée d'image de référence, on effectue au moins l'un de ce qui suit :

   - soumettre la donnée d'image de réception à un algorithme de suppression du bruit ; et
   - produire la donnée d'image de référence sur la base d'une donnée d'image de référence obtenue en moyenne pendant des mesures précédentes.

10. Le procédé (200) de l'une des revendications précédentes, dans lequel déterminer (250) le paramètre de qualité indiquant le caractère de matériau de la plaquette (100) comprend effectuer au moins l'un de :

   - un algorithme de segmentation ; et
   - un algorithme de classement.

11. Le procédé (200) de l'une des revendications précédentes, dans lequel le mouvement relatif entre la plaquette (100) et le dispositif (310) à caméra est effectué par un dispositif (330) d'alignement de plaquette.

12. Le procédé (200) de l'une des revendications précédentes, dans lequel on crée la donnée d'image de réception est créée en outre sur la base de la lumière, qui était réfléchie par la plaquette (100).

13. Une installation d'analyse automatique d'une plaquette (100), dans laquelle l'installation comprend

   - un dispositif (310) à caméra, une source (320) lumineuse, une unité (340) de traitement et un moyen (330) pour effectuer un mouvement relatif entre la plaquette (100) et le dispositif (310) à caméra et de manière ainsi à soumettre, pendant le mouvement relatif entre la plaquette (100) et le dispositif (310) à caméra, la plaquette (100) à une lumière émise par la source (320) lumineuse, dans laquelle la source (320) lumineuse émet la lumière avec une configuration de lumière de référence et dans laquelle la lumière émise pénètre dans la plaquette (100) en mouvement et dans laquelle le mouvement relatif est un mouvement de rotation ;

   dans laquelle :

   - le dispositif (310) à caméra est configuré pour créer, sur la base de la lumière, qui a été émise par la source (320) lumineuse et qui a pénétré dans la plaquette (100) en mouvement, une donnée d'image de réception indiquant une configuration de lumière de réception, un pas (P) maximum de la configuration de lumière de référence étant adapté à un temps de capture d'image du dispositif (310) à caméra ;
   - l'unité (340) de traitement est configurée pour déterminer une différence entre la configuration de lumière de référence et la configuration de lumière de réception sur la base de la donnée d'image de réception et de la donnée d'image de référence ;
   - l'unité (340) de traitement est configurée pour déterminer, sur la base de la différence, un paramètre de qualité indiquant un caractère du matériau de la plaquette (100).

14. Un système (300) de traitement d'une plaquette (100), le système comprenant une installation suivant la revendication 13.

FIG 1

FIG 2

## FIG 3

## FIG 4

# FIG 5

Y⊗ →X

Z

340

310

1101

111

100

V

1102

81

320

# FIG 6

(A)

(B)

P

P

P

81

82

FIG 7

FIG 8

300

300-1

300-2

200

300-3

300-10

FIG 9

300

300-1

300-2

200

300-3

300-10

FIG 10

200

210

220

230

240

250

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2010165095 A1
- US 2015160138 A1

- WO 2011121219 A